(19) Europäisches Patentamt
European Patent Office
Office européen des brevets

(11) **EP 2 296 201 B1**

(12) **FASCICULE DE BREVET EUROPEEN**

(45) Date de publication et mention
de la délivrance du brevet:
**06.01.2016 Bulletin 2016/01**

(51) Int Cl.:
***H01L 41/29*** *(2013.01)*      ***H01L 41/318*** *(2013.01)*

(21) Numéro de dépôt: **10176207.8**

(22) Date de dépôt: **10.09.2010**

(54) **Procédé de fabrication d'une membrane piézoélectrique à actionnement optimisé**

Verfahren zur Herstellung einer piezoelektrischen Membran mit optimierter Funktionsweise

Method of manufacturing a piezoelectric membrane with optimised operation

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **15.09.2009 FR 0904396**

(43) Date de publication de la demande:
**16.03.2011 Bulletin 2011/11**

(73) Titulaire: **Commissariat à l'Énergie Atomique et aux Énergies Alternatives**
**75015 Paris (FR)**

(72) Inventeurs:
• **Defay, Emmanuel**
**38340, VOREPPE (FR)**
• **Le Rhun, Gwenaël**
**38000, GRENOBLE (FR)**

(74) Mandataire: **Esselin, Sophie et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A1- 0 810 676**      **WO-A1-2007/112741**
**WO-A2-03/079409**      **GB-A- 2 444 184**
**US-A1- 2005 134 144**      **US-A1- 2005 185 026**
**US-A1- 2008 239 020**

**Description**

Le domaine de l'invention est celui des microsystèmes et plus particulièrement celui des membranes pouvant être utilisées dans les micropompes ou bien dans les actionneurs piézoélectriques pour imprimante à jet d'encre.

Actuellement, il existe des membranes piézoélectriques couches minces qui utilisent des couches de matériaux piézoélectriques tels que le zirconate titanate de plomb (PZT) ou un alliage d'alumium et de nitrure AlN, décrit dans la demande de brevet américaine US2006/0209128.

Il est notamment connu de la demande de brevet US 2008/239020, un procédé de fabrication d'une membrane comprenant sur un substrat un empilement de couches comportant au moins une couche de matériau piézoélectrique disposée entre une couche d'électrode supérieure et une couche d'électrode inférieure et une couche élastique supportant la couche piézoélectrique.

Les membranes peuvent fonctionner selon deux modes possibles d'actionnement : le mode de coefficient $d_{31}$ ou le mode de coefficient $d_{33}$.

Il est également décrit dans la demande de brevet US 2005/134144 un procédé de fabrication d'une membrane comprenant un substrat, un empilement comprenant un matériau massif piézoélectrique massif, une couche d'électrode supérieure, une couche d'électrode inférieure et une couche élastique, le matériau piézoélectrique étant préalablement polarisé avec une tension de polarisation.

De manière générale, les coefficients $d_{31}$ et $d_{33}$ répondent aux équations suivantes, en fonction de variation de déformation sous l'action d'un champ électrique appliqué sur un matériau de polarisation P :

$$d_{31} = S_1 / E_3$$

$$d_{33} = S_3 / E_3$$

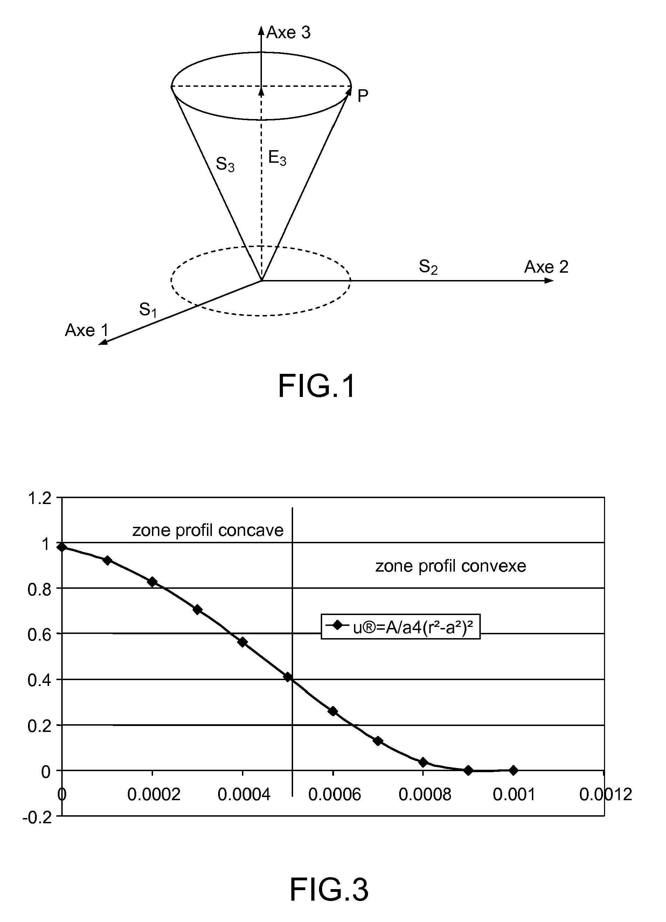

avec $S_1$ correspondant à la déformation selon l'axe 1 et $S_3$ correspondant à la déformation selon l'axe 3, $E_3$ correspondant au champ électrique suivant l'axe 3, tels que schématisés en figure 1.

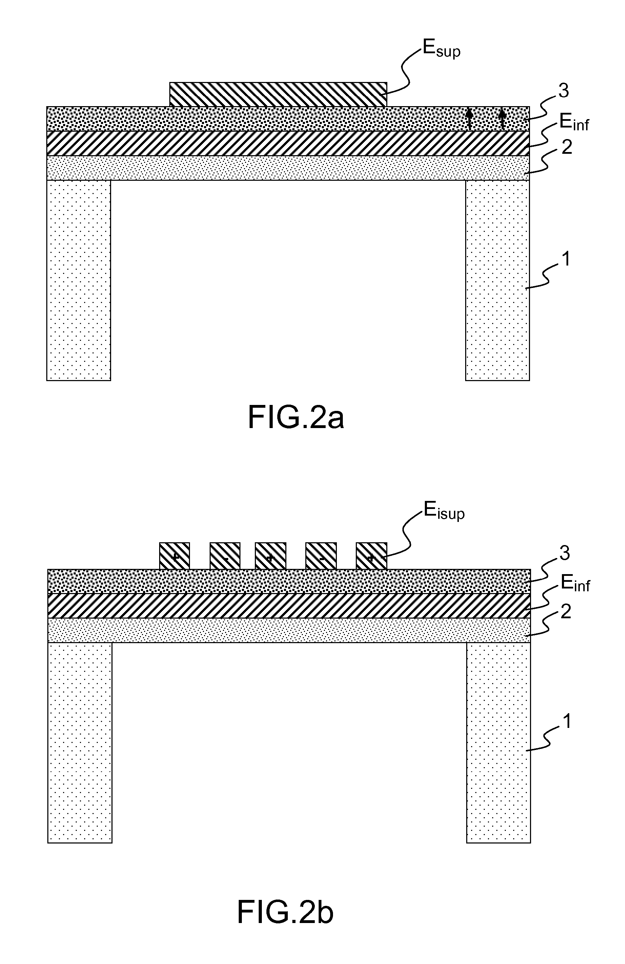

Les modes de fonctionnement dépendent du sens selon lequel le matériau est polarisé et du sens selon lequel on applique un champ électrique d'actionnement. Les figures 2a et 2b illustrent ainsi deux structures typiques d'actionnement de coefficients $d_{31}$ et $d_{33}$. Dans un mode dit «$d_{31}$», la tension est appliquée entre l'électrode supérieure et l'électrode inférieure comme montré en figure 2a. Dans le cas du mode dit «$d_{33}$», la tension est appliquée entre les électrodes supérieures notées + et - sur la figure 2b.

Plus précisément, la structure comporte une membrane réalisée à la surface d'un substrat 1, ladite membrane comportant une couche 3 de matériau piézoélectrique apte à se déformer, à la surface d'une couche élastique 2 et comportant en outre des électrodes d'actionnement, dans le cas décrit en figure 2a, il s'agit d'électrodes inférieure $E_{inf}$ et d'électrode supérieure $E_{sup}$ entre lesquelles sont insérées les couches 2 et 3. Dans le cas de la figure 2b, il s'agit d'électrodes supérieures de commande $E_{isup}$.

En fonctionnement, la membrane a un profil non monotone. C'est-à-dire que la courbure est, à un instant donné, convexe à certains endroits, concave à d'autres. Muralt a montré (Muralt-P; Kohli-M; Maeder-T; Kholkin-A; Brooks-K; Setter-N; Luthier-R, Sensors-and-Actuators-A, 48(2), 157 (1995)), que le profil était à peu près celui illustré en figure 3 qui illustre le profil de courbure d'une membrane mixte couche élastique/couche piézoélectrique. L'abscisse x=0, correspond à la position au centre de la membrane, l'abscisse x=0.001 correspond au bord de la membrane, sur la zone bloquée.

Ainsi, que la membrane fonctionne en régime $d_{33}$ ou $d_{31}$, le matériau piézoélectrique ne doit pas être actionné partout sur la membrane sinon il est contreproductif. En effet, il est indispensable de le faire fonctionner de façon identique sur une zone de courbure de même signe.

Dans un matériau piézoélectrique non ferroélectrique pour lequel il n'y pas de polarisation par le champ électrique (tel que l'AlN ou le ZnO ou le quartz), la déformation dans le plan, $S_p$ répond à l'équation suivante (1) :

$$S_p = d_{31}E = -d_{31}\frac{V}{e_p} \qquad (1)$$

Avec ep épaisseur du matériau piézoélectrique et V la tension appliquée.

Il est à noter et notamment décrit dans la publication de KyongWon Seo, JongSeon Park, HyongJung Kim et al., Micromachined piezoelectric microspeakers fabricated with high quality AlN thin films, Integrated Ferroelectrics, 95 (74-82), pp. 74-82 (2007) que dans le cas de certains matériaux cristallins couramment utilisés tel que AlN, le signe du coefficient $d_{31}$ dépend de l'orientation cristalline du matériau. Ainsi, quand la polarisation du matériau AlN est dirigée comme illustrée sur la figure 2a, le coefficient $d_{31}$ est négatif.

C'est cette déformation piézoélectrique qui est à l'origine d'un moment piézoélectrique qui induit la déflexion de la membrane.

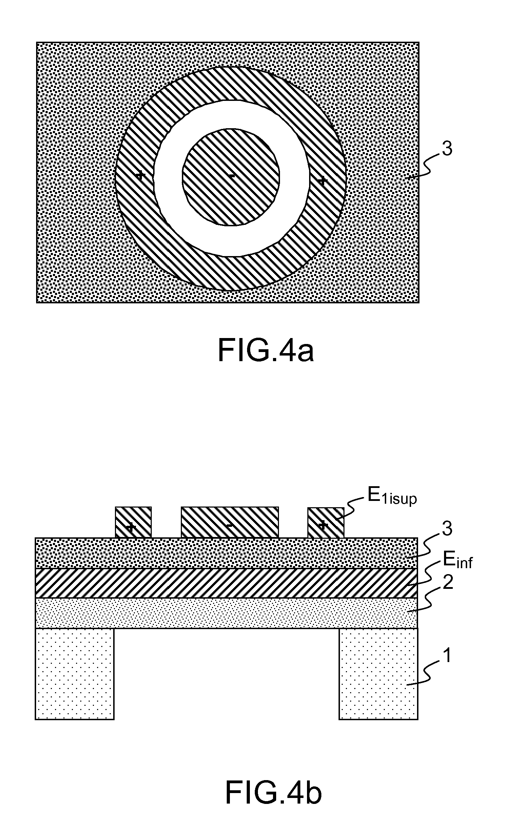

Il est connu d'utiliser un changement de signe de l'excitation piézoélectrique sur un matériau type AlN, avec deux électrodes supérieures distinctes entre le centre de la membrane et le bord de la membrane comme présenté sur les figures 4a et 4b qui illustrent respectivement une vue de dessus et une vue en coupe d'une structure dans laquelle est créée une excitation simultanée dans les deux zones de courbures différentes, de la membrane. On utilise ici un actionnement $d_{31}$ dans les deux zones mais en inversant le signe de la tension appliquée.

Les tensions sont appliquées entre les électrodes supérieures $E_{isup}$ et l'électrode inférieure $E_{inf}$ qui reste à la masse. Cela permet d'appliquer un moment piézoélectrique de signe différent suivant les zones convexe et concave de la membrane, améliorant ainsi l'actionnement.

Dans ce contexte, la présente invention propose une solution permettant d'obtenir une déflexion optimale en utilisant un actionnement mixte de type $d_{31}$ et de type $d_{33}$ dans les deux zones de courbure différentes de la membrane actionnée et compatible par ailleurs avec l'utilisation de matériaux piézoélectriques ferroélectriques qui présentent l'intérêt de pouvoir être repolarisables.

Plus précisément, la présente invention a pour objet un procédé de fabrication d'une membrane à actionnement optimisé comprenant sur un substrat un empilement de couches comportant au moins :

- une couche mince de matériau piézoélectrique disposée entre une couche d'électrode supérieure et une couche d'électrode inférieure et
- une couche élastique supportant ladite couche piézoélectrique, caractérisé en ce que ledit procédé comporte les étapes suivantes :
- la détermination préalable d'au moins une courbe de concavité/convexité de ladite membrane selon un axe parallèle au plan des couches de manière à définir un ensemble de points d'inflexion, permettant d'isoler une première zone et une seconde zone correspondant à une partie concave et une partie convexe ou réciproquement, dans le plan des couches ;

- le dépôt à la surface du substrat d'un empilement de couches comprenant au moins une couche de matériau piézoélectrique, une couche d'électrode inférieure, une couche d'électrode supérieure ;
- la structuration de ladite couche d'électrode supérieure de manière à former des électrodes supérieures et définir au moins ladite première zone de membrane dans laquelle on peut appliquer un champ électrique perpendiculaire au plan de couches et au moins ladite seconde zone dans laquelle on peut appliquer un champ électrique parallèle au plan des couches ;
- la distance entre les électrodes supérieures définies dans la seconde zone, étant inférieure à l'épaisseur de la couche de matériau piézoélectrique. Selon une variante de l'invention, le substrat comporte une cavité sur toute ou partie de l'empilement.

La couche élastique peut ou non être piézoélectrique.

Selon une variante de l'invention, la membrane comporte une première zone centrale et deux secondes zones latérales.

Selon une variante de l'invention, la membrane comprend deux premières zones latérales et une seconde zone centrale.

Selon une variante de l'invention, l'une des zones est centrale et l'autre zone est périphérique de la zone centrale.

Selon une variante de l'invention, le procédé comporte en outre la réalisation d'une couche tampon déposée sur la couche élastique permettant de favoriser la réalisation de la couche de matériau piézoélectrique.

Selon une variante de l'invention, le procédé comporte en outre la réalisation d'une couche d'arrêt de gravure.

Selon une variante de l'invention, la membrane comprend une électrode inférieure enterrée dans la couche de matériau piézoélectrique et présente dans ladite première zone centrale.

Selon une variante de l'invention, le matériau piézoélectrique est de type ferroélectrique.

Selon une variante de l'invention, le matériau ferroélectrique est de type $PbZrTiO_3$ (PZT) ou $PbMgNbTiO_3$ (PMNT) ou $BaFeO_3$ (BST) ou $BaTiO_3$ ou $BiFeO_3$.

Selon une variante de l'invention, le matériau piézoélectrique est un matériau électrostrictif.

Selon une variante de l'invention, le matériau électrostrictif est de type $SrTiO_3$, $BaSrTiO_3$, $Pb(Mg,Nb)TiO_3$.

Selon une variante de l'invention, la couche élastique est en matériau de type silicium, ou un alliage de silicium ($SiO2$, $SiN$) ou $ZrO_2$.

Selon une variante de l'invention, la couche tampon est en $ZrO_2$.

Selon une variante de l'invention, la structuration de la couche d'électrode est réalisée par usinage ionique.

Selon une variante de l'invention, le dépôt de matériau piézoélectrique est effectué par procédé sol-gel.

Selon une variante de l'invention, le procédé comporte en outre la gravure profonde du substrat pour définir une cavité.

Selon une variante de l'invention, le procédé comprend en outre la gravure locale de la couche de matériau piézoélectrique pour permettre la reprise de contact de la couche d'électrode inférieure.

Selon une variante de l'invention, la gravure de la couche de matériau piézoélectrique est effectuée par gravure chimique.

L'invention sera mieux comprise et d'autres avantages apparaîtront à la lecture de la description qui va suivre donnée à titre non limitatif et grâce aux figures annexées parmi lesquelles :

- la figure 1 illustre les polarisations radiale et longitudinale $P_r$ et $P_3$ d'un matériau polarisé ;
- les figures 2a et 2b illustrent deux structures typiques d'actionnement de coefficients $d_{31}$ et $d_{33}$ dans des membranes de l'art connu ;
- la figure 3 illustre le profil de courbure d'une membrane mixte couche élastique/couche piézoélectrique selon l'art connu, en actionnement ;
- les figures 4a et 4b illustrent respectivement une vue de dessus et une vue en coupe d'une structure dans laquelle est créée une excitation simultanée dans les deux zones de courbures différentes d'une membrane selon l'art connu
- les figures 5a et 5b illustrent les points d'inflexion obtenus dans une étape de procédé de l'invention permettant de définir la frontière entre les première et seconde zones dans le cas d'une membrane circulaire ;
- les figures 6a et 6b illustrent les points d'inflexion obtenus dans une étape de procédé de l'invention permettant de définir la frontière entre les première et seconde zones dans le cas d'une membrane carrée ou rectangulaire ;
- la figure 7 illustre une variante de l'invention présentant une première zone centrale et deux secondes zones latérales ;
- la figure 8 illustre une variante de l'invention présentant une seconde zone centrale et deux premières zones latérales ;
- la figure 9 illustre une variante de l'invention présentant une électrode inférieure enterrée ;
- la figure 10 illustre une membrane piézoélectrique présentant plusieurs types d'électrodes inférieures enterrées ;
- la figure 11 illustre une variante de l'invention présentant une couche tampon et une couche d'arrêt de gravure ;
- les figures 12a et 12b illustrent un exemple de géométrie d'électrodes pouvant être utilisées dans une membrane de l'invention ;
- les figures 13a et 13b illustrent un exemple de géométrie d'électrodes et de lignes de points d'inflexion dans le cas d'une membrane très allongée.

Selon l'invention, il est proposé d'utiliser un actionnement mixte de type $d_{31}$ et de type $d_{33}$ dans les deux zones de courbure différente comme présenté en figure 3.

En effet, l'effet $d_{33}$ induit un coefficient de déformation Sp positif et l'effet $d_{31}$ induit un coefficient de déformation Sp négatif. On peut donc imposer des déformations piézoélectriques dans le plan de signe différent, ce qui est nécessaire pour obtenir une déflexion optimale de la membrane.

Pour cela et selon l'invention on procède à la détermination d'une courbe permettant de définir les points d'inflexion et par la même la limite entre les actionneurs fonctionnant en « $d_{31}$ » et les actionneurs fonctionnant en « $d_{33}$ ».

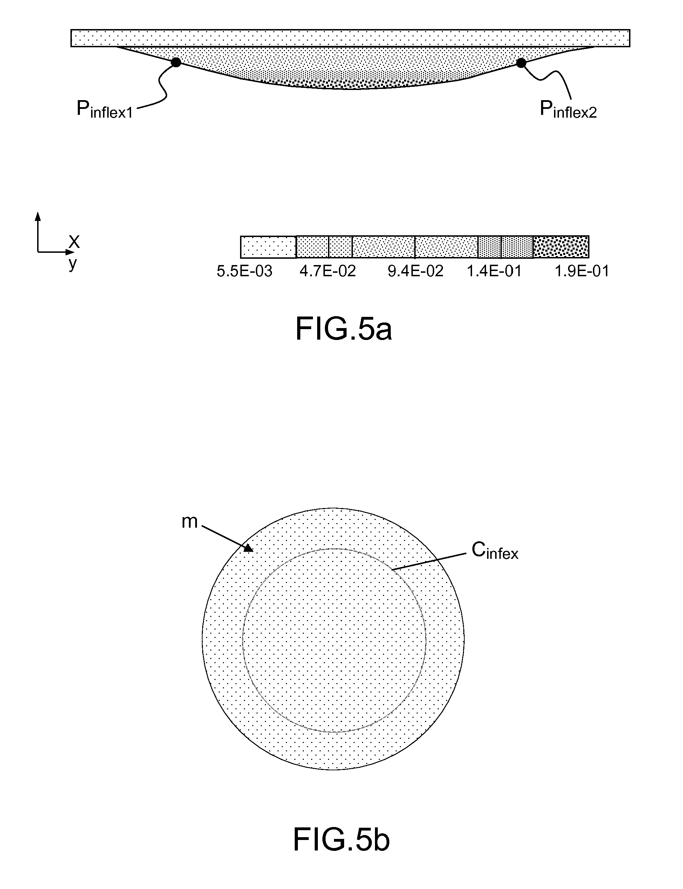

Pour déterminer la courbe sur laquelle se trouvent les points d'inflexion, une méthode est d'utiliser une simulation numérique. Par exemple, on peut utiliser le logiciel Coventor qui donne la déflexion simulée de la structure d'intérêt comme illustré en figure 5a qui met en évidence les deux points d'inflexion $P_{inflex1}$ et $P_{inflex2}$.

En figure 5b, on met en évidence que l'on peut associer tous les points d'inflexion pour en faire une courbe de points d'inflexion $C_{inflex}$, d'une membrane circulaire m.

Ce type de courbe peut être défini par simulation mais également par calcul dans le cas d'une membrane simple. Cependant, dès que la structure est plus complexe, il n'existe plus de solution analytique et il est préférable d'utiliser une modélisation par éléments finis.

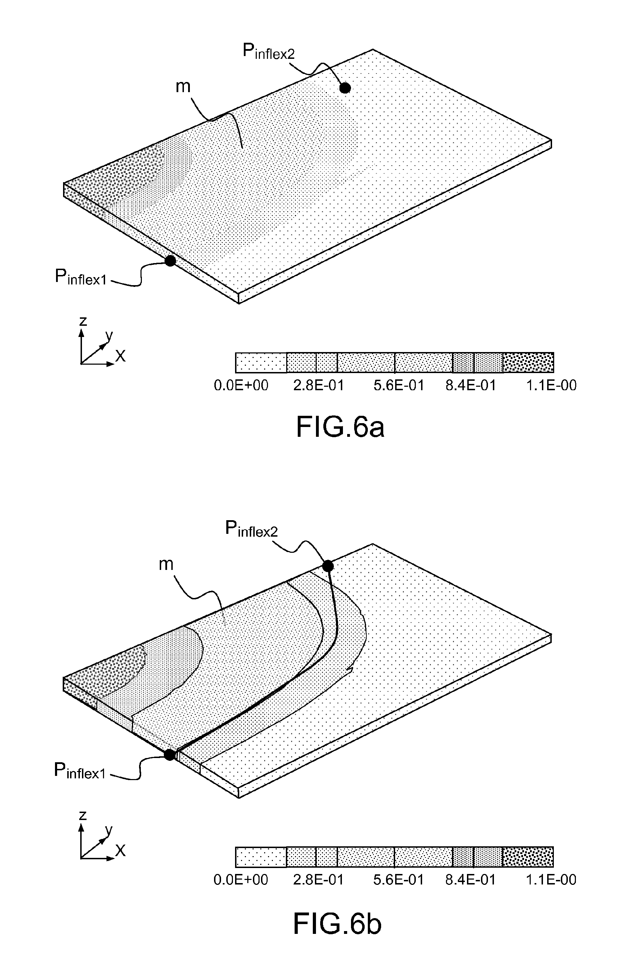

Il est également possible de faire une simulation sur des structures carrées ou rectangulaires comme illustré en figure 6a et 6b. Les points d'inflexion $P_{inflex1}$ et $P_{inflex2}$ sont apparents sur la largeur et la longueur.

La membrane de la présente invention peut fonctionner à champ fort entre le champ coercitif et le champ de claquage avec un matériau piézoélectrique ferroélectrique. Elle peut aussi avantageusement fonctionner avec un matériau électrostrictif de type : $SrTiO_3$, $BaSrTiO_3$, $Pb(Mg,Nb)TiO_3$.

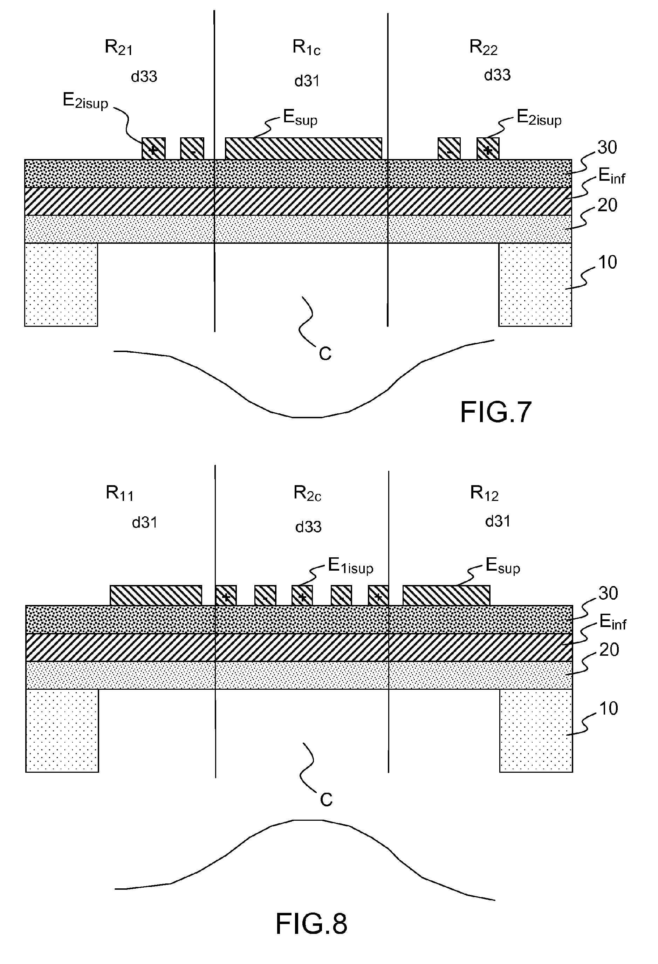

La figure 7 illustre une première variante de l'invention comportant une première zone centrale $R_{1C}$ dans laquelle est déployée l'effet $d_{31}$ et deux secondes zones latérales $R_{21}$ et $R_{22}$ dans lesquelles est déployé l'effet $d_{33}$, au sein d'une couche de matériau piézoélectrique 3 à la surface d'une couche élastique 20 déposée à la surface d'un substrat 10, au sein duquel est réalisée une cavité C. La couche de matériau piézoélectrique est par ailleurs comprise entre une couche d'électrode inférieure $E_{inf}$ et une couche d'électrode supérieure $E_{sup}$ permettant de pouvoir appliquer dans la zone $R_{1c}$ des lignes de champ perpendiculaire au plan des couches comme représenté par les flèches sur ladite figure 7.

Selon une autres variante de l'invention, la structure de membrane telle qu'illustrée en figure 8 comporte une zone centrale $R_{2C}$ à effet $d_{33}$ et deux zones latérales $R_{11}$ et $R_{12}$ à effet $d_{31}$. Les électrodes $E_{1isup}$ en région centrales permettent d'appliquer les lignes de champ parallèles au plan des couches, dans le cas où la distance entre les électrodes $E_{1isup}$ est inférieure à l'épaisseur de la couche de matériau piézoélectrique.

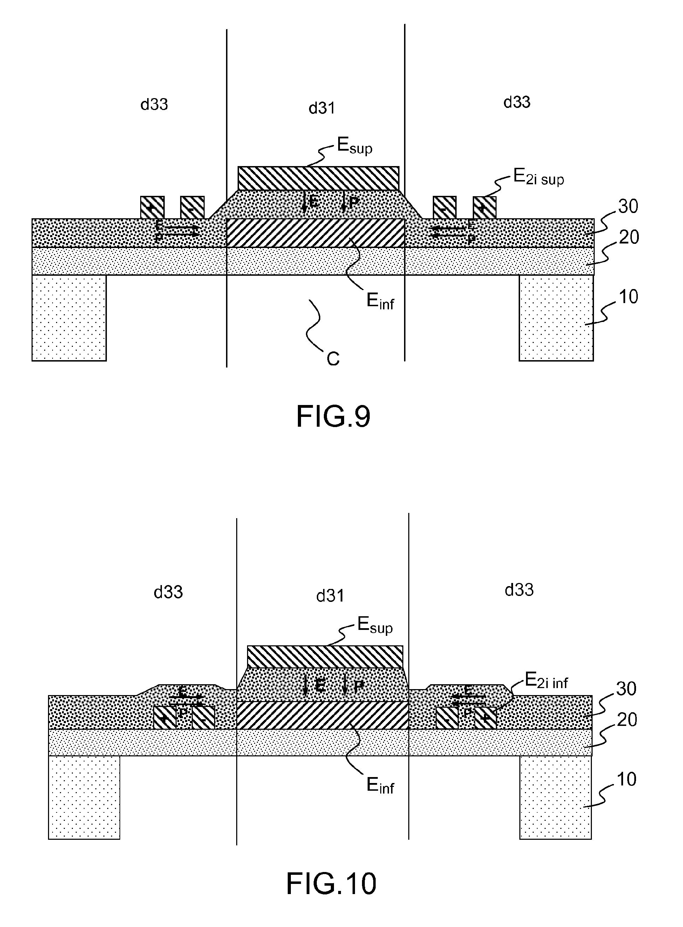

Il est possible d'optimiser le fonctionnement de ce type de structure. En effet, dans les zones latérales dans lesquelles les lignes de champ sont parallèles au plan des couches on a intérêt à ne pas trop perturber les lignes de champ horizontales avec la présence de l'électrode inférieure, c'est à ce titre qu'une variante de l'invention propose de supprimer dans les secondes zones, l'électrode inférieure comme illustré en figure 9, afin de pouvoir appliquer un champ électrique horizontal dans tout le volume de matériau piézoélectrique de la zone $d_{33}$.

Il est à noter que le champ électrique E doit être suffisamment fort pour faire basculer la polarisation dans le sens du champ. Dans la zone $d_{31}$ au centre de la membrane, comme précédemment explicité, le matériau piézoélectrique induit un coefficient de déformation Sp négatif quand on applique un champ électrique. La membrane est donc dirigée vers le bas. Dans les zones dans lesquelles est déployé l'effet appelée $d_{33}$, le matériau piézoélectrique induit un coefficient de déformation Sp positif. La membrane a donc tendance également à aller vers le bas, conformément au raisonnement illustré par la figure 3. Cette solution est aussi valable pour les matériaux électrostrictifs.

De manière générale, le sens du champ électrique n'a pas d'importance que ce soit sur la zone $d_{33}$ ou la zone $d_{31}$. Il est simplement nécessaire de faire apparaître un champ électrique d'une part entre l'électrode inférieure et supérieure de la zone $d_{31}$ et d'autre part entre les électrodes « + » et « - » de la zone $d_{33}$.

Il est à noter que l'on peut aussi optimiser le fonctionnement de ce type de structure en utilisant au mieux l'ensemble du matériau piézoélectrique. En effet, dans les zones latérales dans lesquelles les lignes de champ sont parallèles au plan des couches, on a intérêt à ne pas trop perturber les lignes de champ horizontales avec la présence de l'électrode inférieure tout en exploitant néanmoins l'ensemble de l'épaisseur de couche de matériau piézoélectrique.

On peut ainsi en rapprochant les électrodes $E_{2isup}$ concentrer le champ électrique, cependant ceci est effectué au détriment de l'ensemble de l'épaisseur du matériau piézoélectrique pouvant être utilisée, typiquement la distance entre les électrodes $E_{2isup}$ peut être inférieure à l'épaisseur de la couche piézoélectrique.

Selon une autre variante qui ne fait pas partie de l'invention, il est prévu de structurer l'électrode inférieure en électrode $E_{inf}$ et $E_{2i,inf}$ plutôt que l'électrode supérieure $E_{sup}$ comme illustré en figure 10. Il est alors nécessaire de graver localement la couche de matériau piézoélectrique pour avoir accès aux électrodes enterrées.

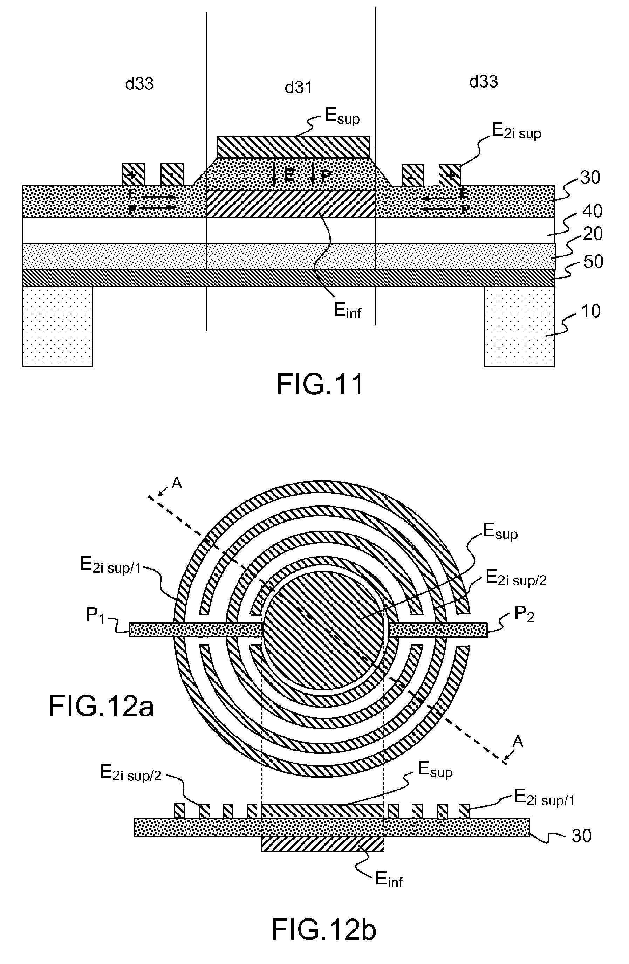

Selon une variante de l'invention, il est proposé comme illustré en figure 11, d'ajouter une couche tampon 40 sur la couche élastique pour améliorer la croissance du matériau piézoélectrique PZT et notamment dans la zone ne présentant pas d'électrode inférieure. En effet de manière classique, les couches de matériau piézoélectrique de type PZT sont réalisées par croissance et il peut être avantageux de déposer au préalable une couche favorisant cette croissance. Dans le cas d'un dépôt de PZT, il peut s'agir d'une couche de $ZrO_2$, particulièrement dans la zone sous l'électrode inférieure.

On peut aussi avantageusement utiliser des couches de nucléation sur l'électrode inférieure de type $TiO_2$ ou $PbTiO_2$.

Par ailleurs, pour réaliser la structure de membrane, on effectue généralement une opération de gravure en face inférieure et l'on peut également avantageusement prévoir pour cela une couche d'arrêt de gravure 50.

Un exemple complet d'empilement de couches est donné ci-après ainsi que les étapes de réalisation permettant de définir les différents jeux d'électrodes utilisés dans la présente invention.

Exemple de réalisation:

- On s'approvisionne en substrat SOI avec une couche mince de Si typiquement de 3$\mu$m d'épaisseur ;
- on effectue le dépôt d'une couche tampon en $ZrO_2$, déposée par pulvérisation réactive d'épaisseur 400nm ;
- on réalise une couche d'électrode inférieure en Pt déposée par pulvérisation d'épaisseur 100nm ;
- on dépose juste avant le Platine, une couche de $TiO_2$ de 20nm par pulvérisation réactive servant de couche d'accroche ;
- on procède à la gravure de la couche d'électrode inférieure en Platine par usinage ionique ;
- on effectue le dépôt de la couche de matériau piézoélectrique $Pb(Zr,Ti)O_3$ (PZT) par procédé sol gel, sur une épaisseur de 1$\mu$m en procédant à une opération de recuit à 700°C;
- on réalise la gravure du PZT par gravure chimique (HF/HCl) ou sèche (gaz chloré/Argon), pour la reprise de contact sur l'électrode inférieure ;
- on réalise le dépôt de l'électrode supérieure en Platine sur une épaisseur de 100nm ;
- on procède à la gravure de l'électrode supérieure par usinage ionique afin de définir les zones $d_{33}$ et $d_{31}$;
- enfin on réalise la gravure face arrière pour libérer la membrane par gravure profonde SF6/C4F8 selon un procédé de l'art connu, jusqu'à atteindre la couche d'arrêt de gravure sur l'oxyde enterré du SOI.

La géométrie des électrodes dédiées aux premières et secondes zones peuvent être variables, les figures 12a et 12b illustrent un exemple de connexions possibles de type circulaires. La vue de dessus en figure 12a montre qu'une partie des électrodes $E_{2isup/1}$ peuvent être connectées à un même premier port $P_1$ que l'électrode centrale $E_{sup}$, les autres électrodes $E_{2isup/2}$ étant connectées à un second port $P_2$.

Dans cet exemple, l'électrode inférieure est connectée au port $P_2$.

Il est à noter qu'il peut tout aussi bien être envisagé de réaliser des géométries d'électrodes rectangulaires typiquement de 1 mm de long.

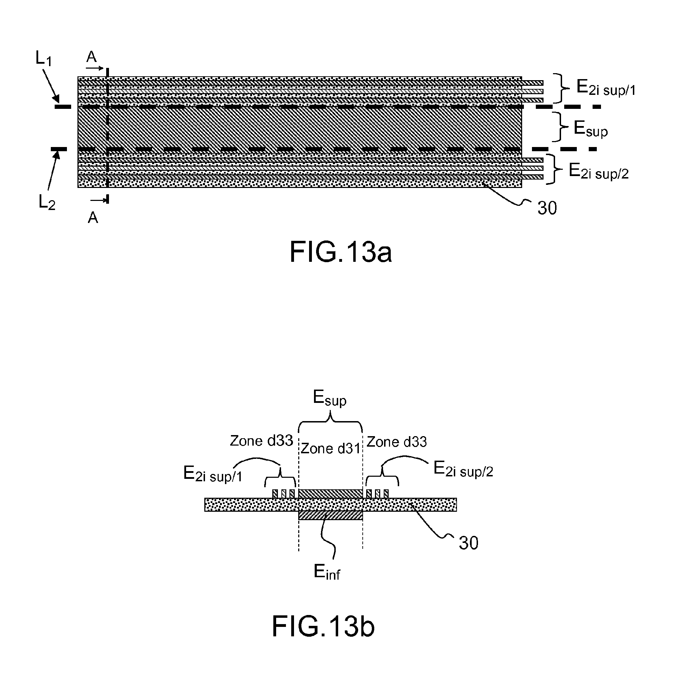

La membrane de forme rectangulaire peut également présenter un ratio longueur/largeur très élevé, comme illustré en figure 13a et 13b et il est à noter que dans ce cas, les points d'inflexion sont situés sur les deux lignes $L_1$ et $L_2$.

**Revendications**

1.  Procédé de fabrication d'une membrane à actionnement optimisé comprenant sur un substrat (10) un empilement de couches comportant au moins :

    - une couche de matériau piézoélectrique (30) disposée entre une couche d'électrode supérieure ($E_{sup}$) et une couche d'électrode inférieure ($E_{inf}$) et
    - une couche élastique (20) supportant ladite couche piézoélectrique,

    ledit procédé comportant les étapes suivantes :

    - la détermination préalable d'au moins une courbe de concavité/convexité de ladite membrane selon un axe parallèle au plan des couches de manière à définir un ensemble de points d'inflexion, permettant d'isoler une première zone et une seconde zone correspondant à une partie concave et une partie convexe ou réciproquement, dans le plan des couches ;
    - le dépôt à la surface du substrat d'un empilement de couches comprenant au moins une couche de matériau piézoélectrique, une couche d'électrode inférieure, une couche d'électrode supérieure,
    **caractérisé en ce que** ledit procédé comporte une structuration de ladite couche d'électrode supérieure de manière à former des électrodes supérieures ($E_{isup}$) et définir au moins ladite première zone de membrane dans laquelle on peut appliquer un champ électrique perpendiculaire au plan de couches et au moins ladite seconde zone dans laquelle on peut appliquer un champ électrique parallèle au plan des couches
    - la distance entre les électrodes supérieures ($E_{isup}$) définies dans la seconde zone, étant inférieure à l'épaisseur de la couche de matériau piézoélectrique étant une couche mince.

2.  Procédé de fabrication d'une membrane selon la revendication 1 , **caractérisé en ce que** le substrat comporte une cavité sur toute ou partie de l'empilement.

3.  Procédé de fabrication d'une membrane selon l'une des revendications 1 ou 2, **caractérisé en ce que** la membrane comporte une première zone centrale ($R_{1c}$) et deux secondes zones latérales ($R_{21}$, $R_{22}$).

4.  Procédé de fabrication d'une membrane selon l'une des revendications 1 ou 2, **caractérisé en ce que** la membrane comprend deux premières zones latérales ($R_{21}$, $R_{22}$) et une seconde zone centrale ($R_{2c}$).

5.  Procédé de fabrication d'une membrane selon l'une des revendications 1 ou 2, **caractérisé en ce que** l'une des zones est centrale et l'autre zone est périphérique de la zone centrale.

6.  Procédé de fabrication d'une membrane selon l'une des revendications précédentes, **caractérisé en ce qu'**il comporte en outre la réalisation d'une couche tampon (40) déposée sur la couche élastique permettant de favoriser la réalisation de la couche de matériau piézoélectrique.

7.  Procédé de fabrication d'une membrane selon l'une des revendications précédentes, **caractérisé en ce qu'**il comporte en outre la réalisation d'une couche d'arrêt de gravure (50).

8.  Procédé de fabrication d'une membrane selon l'une des revendications précédentes, **caractérisé en ce que** la membrane comprend une électrode inférieure enterrée dans la couche de matériau piézoélectrique et présente dans ladite première zone centrale.

9.  Procédé de fabrication d'une membrane selon l'une des revendications 1 à 8, **caractérisé en ce que** le matériau piézoélectrique est de type ferroélectrique.

10.  Procédé de fabrication d'une membrane selon la revendication 9, **caractérisé en ce que** le matériau ferroélectrique est de type $PbZrTiO_3$ (PZT) ou $PbMgNbTiO_3$ (PMNT) ou $BaTiO_3$ ou $BiFeO_3$.

11.  Procédé de fabrication d'une membrane selon l'une des revendications 1 à 10, **caractérisé en ce que** le matériau piézoélectrique est un matériau électrostrictif.

12.  Procédé de fabrication d'une membrane selon la revendication 11, **caractérisé en ce que** le matériau électrostrictif est de type $SrTiO_3$, $BaSrTiO_3$, $Pb(Mg,Nb)TiO_3$.

13.  Procédé de fabrication d'une membrane selon l'une des revendications précédentes **caractérisé en ce que** la couche élastique est en matériau de type silicium, ou un alliage de silicium (Si02, SiN) ou $ZrO_2$.

14.  Procédé de fabrication d'une membrane selon la revendication 13, **caractérisé en ce que** la couche tampon est en $ZrO_2$.

15.  Procédé de fabrication d'une membrane selon l'une des revendications 1 à 14, **caractérisé en ce que** la structuration de la couche d'électrode est réalisée par usinage ionique.

16.  Procédé de fabrication d'une membrane selon l'une des revendications 1 à 15, **caractérisé en ce que** le dépôt de matériau piézoélectrique est effectué par procédé sol-gel.

17. Procédé de fabrication d'une membrane selon l'une des revendications 1 à 16, **caractérisé en ce qu'**il comporte en outre la gravure profonde du substrat pour définir une cavité.

18. Procédé de fabrication d'une membrane selon la revendication 17, **caractérisé en ce qu'**il comprend en outre la gravure locale de la couche de matériau piézoélectrique pour permettre la reprise de contact de la couche d'électrode inférieure.

19. Procédé de fabrication d'une membrane selon la revendication 18, **caractérisé en ce que** la gravure de la couche de matériau piézoélectrique est effectuée par gravure chimique.


**Patentansprüche**

1. Verfahren zur Herstellung einer Membran mit optimierter Aktivierung, die auf einem Substrat (10) einen Stapel von Schichten umfasst, die wenigstens Folgende umfassen:

   - eine Schicht aus piezoelektrischem Material (30), die zwischen einer oberen Elektrodenschicht ($E_{sup}$) und einer unteren Elektrodenschicht ($E_{inf}$) angeordnet ist; und
   - eine flexible Schicht (20), die die piezoelektrische Schicht trägt,

   wobei das Verfahren die folgenden Schritte beinhaltet:

   - vorheriges Ermitteln von wenigstens einer Konkavitäts/Konvexitäts-Kurve der Membran entlang einer Achse parallel zur Ebene der Schichten, um einen Satz von Beugungspunkten zu definieren, so dass eine erste Zone und eine zweite Zone entsprechend einem konkaven Teil und einem konvexen Teil oder umgekehrt in der Ebene der Schichten isoliert werden können;
   - Absetzen, auf der Oberfläche des Substrats, eines Stapels von Schichten, der wenigstens eine Schicht aus piezoelektrischem Material, eine untere Elektrodenschicht, eine obere Elektrodenschicht umfasst,

   **dadurch gekennzeichnet, dass** das Verfahren das Strukturierten der oberen Elektrodenschicht beinhaltet, um obere Elektroden ($E_{isup}$) zu bilden und wenigstens die erste Membranzone, in der ein elektrisches Feld senkrecht zur Ebene von Schichten angelegt werden kann, und wenigstens die zweite Zone zu definieren, in der ein elektrisches Feld parallel zur Ebene der Schichten angelegt werden kann;

   - wobei der Abstand zwischen den in der zweiten Zone definierten oberen Elektroden ($E_{isup}$) kleiner ist als die Dicke der Schicht aus piezoelektrischem Material, die eine dünne Schicht ist.

2. Verfahren zur Herstellung einer Membran nach Anspruch 1, **dadurch gekennzeichnet, dass** das Substrat einen Hohlraum auf dem ganzen Stapel oder einem Teil davon umfasst.

3. Verfahren zur Herstellung einer Membran nach Anspruch 1 oder 2, **dadurch gekennzeichnet, dass** die Membran eine erste zentrale Zone ($R_{1c}$) und zwei zweite laterale Zonen ($R_{21}$, $R_{22}$) umfasst.

4. Verfahren zur Herstellung einer Membran nach Anspruch 1 oder 2, **dadurch gekennzeichnet, dass** die Membran zwei erste laterale Zonen ($R_{21}$, $R_{22}$) und eine zweite zentrale Zone ($R_{2c}$) umfasst.

5. Verfahren zur Herstellung einer Membran nach Anspruch 1 oder 2, **dadurch gekennzeichnet, dass** eine der Zonen zentral und die andere Zone peripher zu der zentralen Zone ist.

6. Verfahren zur Herstellung einer Membran nach einem der vorherigen Ansprüche, **dadurch gekennzeichnet, dass** es ferner die Erzeugung einer auf die elastische Schicht abgesetzten Pufferschicht (40) zum Fördern der Erzeugung der Schicht aus piezoelektrischem Material umfasst.

7. Verfahren zur Herstellung einer Membran nach einem der vorherigen Ansprüche, **dadurch gekennzeichnet, dass** es ferner das Erzeugen einer Ätzstoppschicht (50) beinhaltet.

8. Verfahren zur Herstellung einer Membran nach einem der vorherigen Ansprüche, **dadurch gekennzeichnet, dass** die Membran eine in der Schicht aus piezoelektrischem Material eingebettete und in der ersten zentralen Zone befindliche untere Elektrode umfasst.

9. Verfahren zur Herstellung einer Membran nach einem der Ansprüche 1 bis 8, **dadurch gekennzeichnet, dass** das piezoelektrische Material vom ferroelektrischen Typ ist.

10. Verfahren zur Herstellung einer Membran nach Anspruch 9, **dadurch gekennzeichnet, dass** das ferroelektrische Material vom Typ $PbZrTiO_3$ (PZT) oder $PbMgNbTiO_3$ (PMNT) oder $BaTiO_3$ oder $BiFeO_3$ ist.

11. Verfahren zur Herstellung einer Membran nach einem der Ansprüche 1 bis 10, **dadurch gekennzeichnet, dass** das piezoelektrische Material ein elektrostriktives Material ist.

12. Verfahren zur Herstellung einer Membran nach Anspruch 11, **dadurch gekennzeichnet, dass** das elektrostriktive Material vom Typ $SrTiO_3$, $BaSrTiO_3$, $Pb(Mg, Nb)TiO_3$ ist.

13. Verfahren zur Herstellung einer Membran nach einem der vorherigen Ansprüche, **dadurch gekennzeichnet, dass** die elastische Schicht aus einem Material des Siliciumtyps oder aus einer Siliciumlegierung ($SiO_2$, SiN) oder $ZrO_2$ ist.

14. Verfahren zur Herstellung einer Membran nach Anspruch 13, **dadurch gekennzeichnet, dass** die Pufferschicht aus $ZrO_2$ ist.

15. Verfahren zur Herstellung einer Membran nach einem der Ansprüche 1 bis 14, **dadurch gekennzeichnet, dass** die Struktur der Elektrodenschicht durch Ionenbearbeitung erzeugt wird.

16. Verfahren zur Herstellung einer Membran nach einem der Ansprüche 1 bis 15, **dadurch gekennzeichnet, dass** das piezoelektrische Material mit einem Sol-Gel-Verfahren abgesetzt wird.

17. Verfahren zur Herstellung einer Membran nach einem der Ansprüche 1 bis 16, **dadurch gekennzeichnet, dass** es ferner das Tiefenätzen des Substrats beinhaltet, um einen Hohlraum zu definieren.

18. Verfahren zur Herstellung einer Membran nach Anspruch 17, **dadurch gekennzeichnet, dass** es ferner das lokale Ätzen der Schicht aus piezoelektrischem Material beinhaltet, um einen erneuten Kontakt mit der unteren Elektrodenschicht zuzulassen.

19. Verfahren zur Herstellung einer Membran nach Anspruch 18, **dadurch gekennzeichnet, dass** die Schicht aus piezoelektrischem Material durch chemisches Ätzen geätzt wird.

## Claims

1. A method for manufacturing a membrane with optimised activation, comprising, on a substrate (10), a stack of layers at least comprising:

   - a layer of piezoelectric material (30) disposed between an upper electrode layer ($E_{sup}$) and a lower electrode layer ($E_{inf}$); and
   - a flexible layer (20) supporting said piezoelectric layer,

said method comprising the following steps:

   - previously determining at least one concavity/convexity curve for said membrane along an axis parallel to the plane of said layers so as to define a set of inflection points, allowing a first zone and a second zone to be isolated, which zones correspond to a concave section and to a convex section or vice versa, in the plane of said layers;
   - depositing, on the surface of said substrate, a stack of layers comprising at least one layer of piezoelectric material, one lower electrode layer, one upper electrode layer,
   **characterised in that** said method comprises structuring said upper electrode layer so as to form upper electrodes ($E_{isup}$) and to define at least said first zone of said membrane, in which an electric field can be applied perpendicular to the plane of layers, and at least said second zone, in which an electric field can be applied parallel to the plane of said layers;
   - with the distance between said upper electrodes ($E_{isup}$) defined in said second zone being less than the thickness of said layer of piezoelectric material, which layer is a thin layer.

2. The method for manufacturing a membrane according to claim 1, **characterised in that** said substrate comprises a cavity on all or part of said stack.

3. The method for manufacturing a membrane according to any one of claims 1 or 2, **characterised in that** said membrane comprises one first central zone ($R_{1c}$) and two second lateral zones ($R_{21}$, $R_{22}$).

4. The method for manufacturing a membrane according to any one of claims 1 or 2, **characterised in that** said membrane comprises two first lateral zones ($R_{21}$, $R_{22}$) and one second central zone ($R_{2c}$).

5. The method for manufacturing a membrane according to any one of claims 1 or 2, **characterised in that** one of said zones is central and the other zone is peripheral to said central zone.

6. The method for manufacturing a membrane according to any one of the preceding claims, **characterised in that** it further comprises the production of a buffer layer (40) deposited on said flexible layer, allowing the production of said piezoelectric material layer to be promoted.

7. The method for manufacturing a membrane according to any one of the preceding claims, **characterised in that** it further comprises the production of an etched barrier layer (50).

8. The method for manufacturing a membrane according to any one of the preceding claims, **characterised in that** said membrane comprises a lower electrode embedded in said layer of piezoelectric material and present in said first central zone.

9. The method for manufacturing a membrane according to any one of claims 1 to 8, **characterised in that** said piezoelectric material is of the ferroelectric type.

10. The method for manufacturing a membrane according to claim 9, **characterised in that** said ferroelectric material is of the $PbZrTiO_3$ (PZT) or the $PbMgNbTiO_3$ (PMNT) or the $BaTiO_3$ or the $BiFeO_3$ type.

11. The method for manufacturing a membrane according to any one of claims 1 to 10, **characterised in that** said piezoelectric material is an electrostrictive material.

12. The method for manufacturing a membrane according to claim 11, **characterised in that** said electrostrictive material is of the $SrTiO_3$, $BaSrTiO_3$, $Pb(Mg, Nb)TiO_3$ type.

13. The method for manufacturing a membrane according to any one of the preceding claims, **characterised in that** said flexible layer is made of a material of the silicon type or is a silicon alloy (SiO, SiN) or $ZrO_2$.

14. The method for manufacturing a membrane according to claim 13, **characterised in that** said buffer layer is made of $ZrO_2$.

15. The method for manufacturing a membrane according to any one of claims 1 to 14, **characterised in that** the structure of said electrode layer is produced by ionic machining.

16. The method for manufacturing a membrane according to any one of claims 1 to 15, **characterised in that** said piezoelectric material is deposited using a sol-gel method.

17. The method for manufacturing a membrane according to any one of claims 1 to 16, **characterised in that** it further comprises the deep etching of said substrate in order to define a cavity.

18. The method for manufacturing a membrane according to claim 17, **characterised in that** it further comprises the local etching of said piezoelectric material layer to allow the renewal of contact with said lower electrode layer.

19. The method for manufacturing a membrane according to claim 18, **characterised in that** said piezoelectric material layer is etched by chemical etching.

FIG.1

FIG.3

FIG.2a

FIG.2b

FIG.4a

FIG.4b

FIG.5a

FIG.5b

**FIG.6a**

**FIG.6b**

FIG.7

FIG.8

d33       d31       d33

$E_{sup}$

$E_{2i\,sup}$

E   P

E   P

E   P

30

20

$E_{inf}$

10

C

## FIG.9

d33       d31       d33

$E_{sup}$

E   P

E   P

E   P

$E_{2i\,inf}$

30

20

$E_{inf}$

10

## FIG.10

FIG.11

FIG.12a

FIG.12b

$L_1$

A →

$E_{2i\ sup/1}$

$E_{sup}$

$E_{2i\ sup/2}$

$L_2$

A →

A

30

## FIG.13a

$E_{sup}$

Zone d33

Zone d31

Zone d33

$E_{2i\ sup/1}$

$E_{2i\ sup/2}$

30

$E_{inf}$

## FIG.13b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060209128 A
- US 2008239020 A
- US 2005134144 A

**Littérature non-brevet citée dans la description**

- **MURALT-P ; KOHLI-M ; MAEDER-T ; KHOLKIN-A ; BROOKS-K ; SETTER-N ; LUTHIER-R.** *Sensors-and-Actuators-A,* 1995, vol. 48 (2), 157
- **KYONGWON SEO ; JONGSEON PARK ; HYONGJUNG KIM et al.** Micromachined piezoelectric microspeakers fabricated with high quality AIN thin films. *Integrated Ferroelectrics,* 2007, vol. 95 (74-82), 74-82